# EUROPEAN PATENT APPLICATION

(11) **EP 4 819 777 A1**
(43) Date of publication of application: **07.10.2026**
(21) Application number: 24915428.7
(22) Date of filing: 27.12.2024
(51) Int. Cl.: H05K 5/00, H05K 1/03, H05K 1/02, H04M 1/02

(54) **PRINTED CIRCUIT BOARD AND ELECTRONIC DEVICE INCLUDING PRINTED CIRCUIT BOARD**

(30) Priority: 03.01.2024 KR 20240001140; 17.04.2024 KR 20240051527
(71) Applicant: Samsung Electronics Co., Ltd., Suwon-si, Gyeonggi-do 16677 (KR)
(72) Inventor: SONG, Jiyoon, Suwon-si, Gyeonggi-do 16677 (KR); OH, Seonglo, Suwon-si, Gyeonggi-do 16677 (KR); YU, Garam, Suwon-si, Gyeonggi-do 16677 (KR); SHIN, Jongwoo, Suwon-si, Gyeonggi-do 16677 (KR); LIM, Gun, Suwon-si, Gyeonggi-do 16677 (KR)
(74) Representative: Gulde & Partner
(86) International application number: PCT/KR2024/021208
(87) International publication number: WO 2025/147016

(57) **Abstract**

An electronic device, according to an embodiment disclosed in the present document, may include an electronic component. In the embodiment, the electronic device may include a printed circuit board including a conductive layer. In the embodiment, the electronic device may include a flexible printed circuit board that connects the electronic component and the printed circuit board, and includes a first portion spaced apart from the printed circuit board by a first distance and a second portion spaced apart from the printed circuit board by a second distance smaller than the first distance. In the embodiment, the printed circuit board may include: a first region from which the conductive layer is removed and which overlaps the second portion of the flexible printed circuit board in a direction perpendicular to one surface of the printed circuit board and; and a second region excluding the first region. Various other embodiments are possible.

## Description

### [Technical Field]

Various embodiments disclosed herein relate to an electronic device including a foldable flexible printed circuit board.

### [Background Art]

As portable electronic devices achieve higher performance, electronic components performing various functions are being disposed inside the electronic devices. The electronic components may be connected to a printed circuit board of an electronic device and may be controlled through a processor connected to the printed circuit board.

Meanwhile, electronic devices are gradually becoming slimmer, and accordingly, the electronic components may be densely disposed in a limited space. In this case, noise may be induced between a plurality of electronic components.

The above information may be provided as related art for the purpose of facilitating an understanding of the disclosure. No assertion or determination is made as to whether any of the foregoing may be considered prior art with respect to the present disclosure.

### [Disclosure of Invention]

### [Technical Problem]

A frame forming a side surface exterior of an electronic device may be used as an antenna capable of transmitting a communication signal or receiving a communication signal by being electrically connected to a communication module. Electrical noise generated when a communication signal is transmitted or received through the frame may be easily induced to an electronic component (e.g., a camera module) disposed adjacent to the frame. For example, when a communication signal is transmitted, electrical noise generated in a printed circuit board connected to the communication module may be induced to an electronic component adjacent to the printed circuit board. Electrical noise generated when a communication signal is transmitted or received may be induced to a peripheral electronic component in various ways. In an embodiment, when a flexible printed circuit board connecting an electronic component to a printed circuit board contacts or is adjacent to the printed circuit board, electrical noise related to a communication signal may be induced from the printed circuit board to the flexible printed circuit board. As unnecessary electrical noise is induced to the flexible printed circuit board connected to the electronic component, a malfunction or defect may occur in the electronic component. For example, when a communication signal is transmitted or received, electrical noise generated in a printed circuit board may be induced to a flexible printed circuit board of a camera module. Accordingly, a signal related to a camera function transmitted from the printed circuit board may be affected by interference, and the camera function may malfunction.

The technical subjects pursued in the disclosure are not limited to the above-described technical subjects, and other technical subjects not mentioned herein may be clearly understood from the following description by those skilled in the art to which the disclosure pertains

### [Solution to Problem]

An electronic device, according to an embodiment disclosed in the present document, may include an electronic component. In the embodiment, the electronic device may include a printed circuit board including a conductive layer. In the embodiment, the electronic device may include a flexible printed circuit board that connects the electronic component and the printed circuit board, and includes a first portion spaced apart from the printed circuit board by a first distance and a second portion spaced apart from the printed circuit board by a second distance smaller than the first distance. In the embodiment, the printed circuit board may include: a first region from which the conductive layer is removed and which overlaps the second portion of the flexible printed circuit board in a direction perpendicular to one surface of the printed circuit board and; and a second region excluding the first region.

An electronic device according to an embodiment disclosed herein may include an electronic component. In the embodiment, the electronic device may include a printed circuit board including a conductive layer. In the embodiment, the electronic device may include a flexible printed circuit board that connects the electronic component and the printed circuit board, and includes a first portion spaced apart from the printed circuit board by a first distance and a second portion spaced apart from the printed circuit board by a second distance smaller than the first distance. In an embodiment, the printed circuit board may include a first region 440A overlapping the second portion of the flexible printed circuit board in a direction perpendicular to one surface of the printed circuit board, and a second region 440B other than the first region. In an embodiment, the first region of the printed circuit board may include a first layer region 441 and a second layer region 442 disposed between the first layer region and the second portion of the flexible printed circuit board, the conductive layer being removed from the second layer region.

According to an embodiment of the disclosure, a printed circuit board may be electrically connected to an electronic component disposed in an electronic device via a flexible printed circuit board. In an embodiment, the flexible printed circuit board may include a first portion spaced apart from the printed circuit board by a first distance and a second portion spaced apart from the printed circuit board by a second distance smaller than the first distance. In an embodiment, the printed circuit board may include a first region overlapping the second portion of the flexible printed circuit board in a direction perpendicular to one surface of the printed circuit board, and a second region other than the first region. In an embodiment, the first region of the printed circuit board may include a first layer region and a second layer region disposed between the first layer region and the second portion of the flexible printed circuit board, the conductive layer being removed from the second layer region.

### [Advantageous Effects of Invention]

According to various embodiments disclosed herein, a printed circuit board may be electrically connected to an electronic component via a flexible printed circuit board. The printed circuit board may include a fill cut structure in which a conductive layer is removed from one region overlapping the flexible printed circuit board. For example, in the printed circuit board, a region that may come into contact with the flexible printed circuit board may be formed only of an insulating layer. Accordingly, a phenomenon in which noise generated in the printed circuit board is induced to the flexible printed circuit board as the printed circuit board and the flexible printed circuit board come into contact with or are adjacent to each other may be suppressed or reduced.

In addition, in the printed circuit board, in a region that may come into contact with the flexible printed circuit board, a layer adjacent to the flexible printed circuit board may be formed of an insulating layer, and a layer relatively spaced apart from the flexible printed circuit board and disposed below the insulating layer may be formed of a conductive layer in which signal wiring is formed. In this case, since a region in which the flexible printed circuit board comes into contact with or is adjacent to the printed circuit board is a region formed of an insulating material within one region of the printed circuit board, a phenomenon in which noise generated in the printed circuit board is induced to the flexible printed circuit board may be suppressed or reduced.

Advantageous effects obtainable from the disclosure are not limited to those mentioned above, and other effects not mentioned herein may be clearly understood from the following description by those skilled in the art to which the disclosure pertains.

### [Brief Description of Drawings]

With regard to the description of the drawings, the same or similar reference numerals may be used to refer to the same or similar elements.
FIG. 1 is a block diagram illustrating an electronic device in a network environment according to various embodiments.
FIG. 2A is a front perspective view of an electronic device according to an embodiment of the disclosure.
FIG 2B is a rear perspective view of the electronic device of FIG. 2A according to an embodiment of the disclosure.
FIG. 3 is an exploded perspective view of the electronic device of FIG. 2A, according to an embodiment of the disclosure.
FIG. 4 is a rear view of an electronic device illustrating a state in which a printed circuit board and a camera module are connected via a flexible printed circuit board according to an embodiment of the disclosure.
FIG. 5A is a view illustrating a printed circuit board disposed in a housing, as viewed from a rear side of an electronic device, according to an embodiment of the disclosure.
FIG. 5B is a rear view of the printed circuit board according to an embodiment of the disclosure.
FIG. 5C is a perspective view of the printed circuit board according to an embodiment of the disclosure.
FIG. 6 is a cross-sectional view taken along line A-A illustrated in FIG. 2B.
FIG. 7A is a view illustrating an embodiment in which a conductive layer is removed from a first region of a printed circuit board according to an embodiment of the disclosure.
FIG. 7B is a view illustrating an embodiment in which a conductive layer is removed from some layers of a first region of a printed circuit board according to an embodiment of the disclosure.
FIG. 8 is a cross-sectional view taken along line A-A illustrated in FIG. 2B.

### [Mode for the Invention]

In the following description, various embodiments of the disclosure will be described with reference to the accompanying drawings. It is to be understood that various embodiments of the disclosure and terms for describing the embodiments are not intended to limit the technical features disclosed herein to specific embodiments, and that the embodiments include various modifications, equivalents, or alternatives of the corresponding embodiments.

In relation to the description of the drawings, similar reference numerals may be used for similar or related components. The singular form of a noun corresponding to an item may include one item or a plurality of items unless the context clearly indicates otherwise.

As used herein, each of such phrases as "A or B," "at least one of A and B," "at least one of A or B," "A, B, or C,""at least one of A, B, and C," and "at least one of A, B, or C," may include all possible combinations of the items enumerated together in a corresponding one of the phrases. Such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

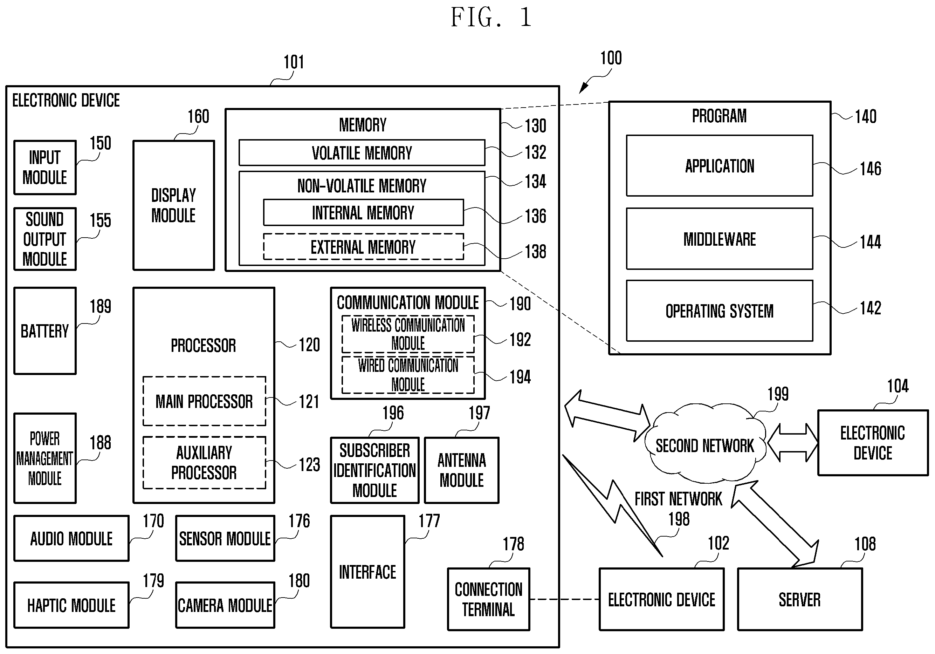

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{TM}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

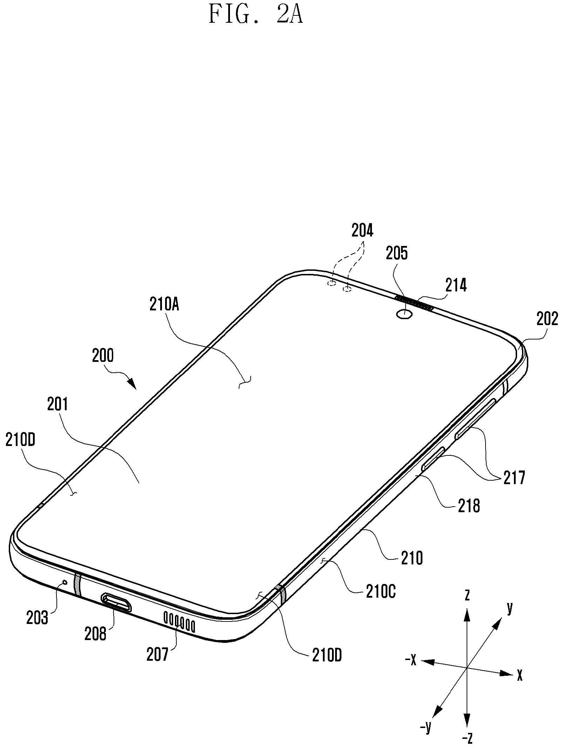

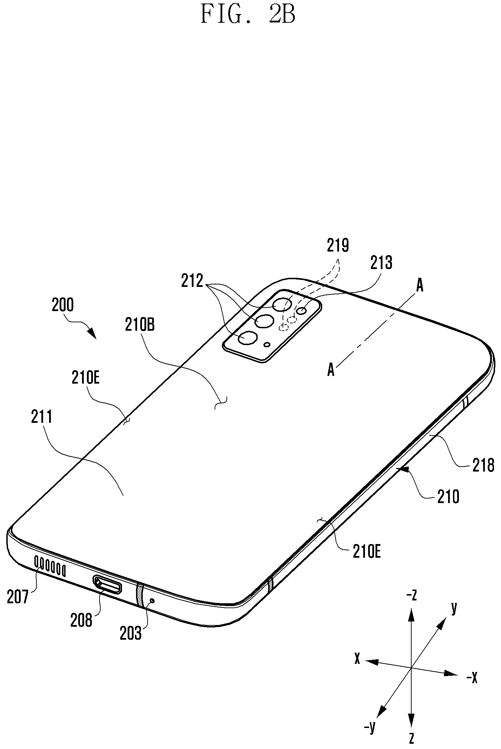

FIG. 2A is a front perspective view of an electronic device according to an embodiment of the disclosure. FIG 2B is a rear perspective view of the electronic device of FIG. 2A according to an embodiment of the disclosure.

An electronic device 200 described below may include at least one of the components of the electronic device 101 described above with reference to FIG. 1.

Referring to FIGS. 2A and 2B, the electronic device 200 according to an embodiment may include a housing 210 including a first surface (or front surface) 210A, a second surface (or rear surface) 210B, and a side surface 210C surrounding a space between the first surface 210A and the second surface 210B. In an embodiment (not illustrated), the housing 210 may refer to a structure forming some of the first surface 210A, the second surface 210B, and the side surface 210C of FIG. 2A. According to an embodiment, the first surface 210A may be formed, at least in part, by a front surface plate 202 that is substantially transparent (e.g., a glass plate including various coating layers or a polymer plate). The second surface 210B may be formed by a rear surface plate 211 that is substantially opaque. The rear surface plate 211 may be formed of, for example, coated or colored glass, ceramic, polymer, metal (e.g., aluminum, stainless steel (STS), or magnesium), or a combination of at least two of the foregoing materials. The side surface 210C may be formed by a side surface bezel structure 218 or "side surface member" coupled to the front surface plate 202 and the rear surface plate 211 and including metal and/or polymer. In some embodiments, the rear surface plate 211 and the side bezel surface structure 218 may be integrally formed and may include the same material (e.g., a metal material such as aluminum).

In the illustrated embodiment, the front surface plate 202 may include, at opposite long edges thereof, first regions 210D bent from the first surface 210A toward the rear surface plate and extending seamlessly. In the illustrated embodiment (see FIG. 2B), the rear surface plate 211 may include, at opposite long edges thereof, second regions 210E bent from the second surface 210B toward the front surface plate and extending seamlessly. In some embodiments, the front surface plate 202 or the rear surface plate 211 may include only one of the first regions 210D or one of the second regions 210E. In some embodiments, the front surface plate 202 may not include the first region and the second region, and may include only a flat surface disposed parallel to the second surface 210B. In the above-described embodiments, when viewed from a side of the electronic device, the side surface bezel structure 218 may have a first thickness (or width) at the sides of the side surface that do not include the first regions 210D or the second region 210E, and may have a second thickness smaller than the first thickness at the sides of the side surface that include the first regions 210D or the second regions 210E.

According to an embodiment, the electronic device 200 may include at least one of a display 201, an input device 203, acoustic output devices 207 and 214, sensor modules 204 and 219, camera modules 205 and 212, key input devices 217, an indicator (not illustrated), and a connector 208. In some embodiments, at least one of the components (e.g., the key input devices 217 or the indicator) of the electronic device 200 may be omitted or another component may be additionally included.

The display 201 may be visually exposed through, for example, a substantial portion of the front surface plate 202. In an embodiment, at least a portion of the display 201 may be exposed through the front surface plate 202 forming the first surface 210A and the first regions 210D of the side surface 210C. The display 201 may be coupled to or disposed adjacent to touch detection circuitry, a pressure sensor capable of measuring an intensity (pressure) of touch, and/or a digitizer configured to detect a stylus pen of a magnetic-field type. In some embodiments, at least some of the sensor modules 204 and 219 and/or at least some of the key input devices 217 may be disposed in the first regions 210D and/or the second regions 210E.

The input device 203 may include a microphone 203. In some embodiments, the input device 203 may include a plurality of microphones 203 arranged to detect a direction of sound. The acoustic output devices 207 and 214 may include speakers 207 and 214. The speakers 207 and 214 may include an external speaker 207 and a receiver 214 for a call. In some embodiments, the microphone 203, the speakers 207 and 214, and the connector 208 may be at least partially disposed in an inner space of the electronic device 200, and may be exposed to an external environment through at least one hole formed in the housing 210. In some embodiments, the hole formed in the housing 210 may be commonly used for the microphone 203 and the speakers 207 and 214. In some embodiments, the acoustic output devices 207 and 214 may include a speaker (e.g., a piezo speaker) operated without a hole formed in the housing 210.

The sensor modules 204 and 219 may generate an electrical signal or data value corresponding to an operating state inside the electronic device 200 or an environmental state outside the electronic device 200. The sensor modules 204 and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 (e.g., a heart rate monitor (HRM) sensor) disposed on the second surface 210B of the housing 210. The fingerprint sensor may be disposed on the first surface 210A of the housing 210 (e.g., a home key button), in a portion of the second surface 210B, and/or below the display 201. The electronic device 200 may further include a sensor module (not illustrated), for example, at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 205 and 212 may include a first camera module 205 disposed on the first surface 210A of the electronic device 200, a second camera module 212 disposed on the second surface 210B, and/or a flash 213. The camera modules 205 and 212 may include one or more lenses, an image sensor, and/or an image signal processor. The flash 213 may include, for example, a light-emitting diode or a xenon lamp. In some embodiments, two or more lenses (e.g., a wide-angle lens, an ultra-wide-angle lens, or a telephoto lens) and image sensors may be disposed on one surface of the electronic device 200.

The key input devices 217 may be disposed on the side surface 210C of the housing 210. In an embodiment, the electronic device 200 may not include some or all of the above-mentioned key input devices 217, and the key input devices 217 not included may be implemented in another form, such as soft keys on the display 201. In an embodiment, the key input devices 217 may be implemented using pressure sensors included in the display 201.

The indicator may be disposed, for example, on the first surface 210A of the housing 210. The indicator may provide, for example, state information of the electronic device 200 in an optical form (e.g., through a light-emitting element). In an embodiment, the light-emitting element may provide, for example, a light source operated in conjunction with the operation of the camera module 205. The indicator may include, for example, a light-emitting diode (LED), an infrared (IR) LED, and/or a xenon lamp.

The connector hole 208 may include a first connector hole 208 capable of accommodating a connector (e.g., a universal serial bus (USB) connector) for transmitting and receiving power and/or data to and from an external electronic device, and/or a second connector hole (or earphone jack) (not illustrated) capable of accommodating a connector for transmitting and receiving an audio signal to and from an external electronic device.

Some camera modules 205 among the camera modules 205 and 212, some sensor modules 204 among the sensor modules 204 and 219, or the indicator may be arranged to be visually exposed through the display 201. For example, the camera modules 205, the sensor modules 204, or the indicator may be disposed in an inner space of the electronic device 200 so as to contact an external environment through an opening or a transmission region of the display 201 perforated to the front surface plate 202. According to an embodiment, a region in which the display 201 and the camera modules 205 face each other may be formed as a transmission region having a predetermined transmittance, as a portion of a region for displaying content. According to an embodiment, the transmission region may be formed to have a transmittance ranging from about 5% to about 20%. The transmission region may include a region overlapping an effective region (e.g., a field-of-view region) of the camera modules 205 through which light for forming an image on the image sensor passes. For example, the transmission region of the display 201 may include a region having a lower pixel density than a surrounding region. For example, the transmission region may replace the opening. For example, the camera modules 205 may include an under-display camera (UDC). In an embodiment, some sensor modules 204 may be disposed to perform functions thereof without being visually exposed through the front surface plate 202 from the inner space of the electronic device. For example, in this case, a perforated opening may be unnecessary in a region of the display 201 facing the sensor module.

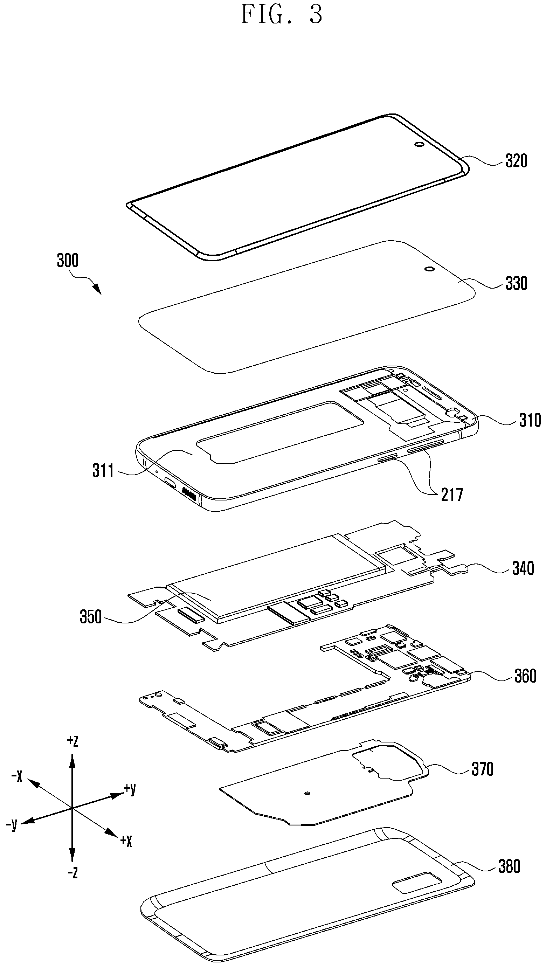

According to an embodiment, an electronic device 200 may have a bar type or plate type exterior, but the disclosure is not limited thereto. For example, the illustrated electronic device 200 may be a part of a foldable electronic device, a slidable electronic device, a stretchable electronic device, and/or a rollable electronic device. The terms "foldable electronic device," "slidable electronic device," "stretchable electronic device," and/or "rollable electronic device" may refer to an electronic device in which a display (e.g., the display 330 of FIG. 3) is bendable so that at least a portion of the display may be folded, wound or rolled, at least partially expanded in area, and/or accommodated inside a housing (e.g., the housing 210 of FIGS. 2A and 2B). The foldable electronic device, the slidable electronic device, the stretchable electronic device, and/or the rollable electronic device may be used by expanding a screen display region according to a user's need, by unfolding the display or exposing a wider area of the display to the outside.

FIG. 3 is an exploded perspective view of the electronic device of FIG. 2A, according to an embodiment of the disclosure.

The electronic device 300 of FIG. 3 may be at least partially similar to the electronic device 200 of FIG. 2b, or may include another embodiment of an electronic device.

Referring to FIG. 3, the electronic device 300 (e.g., the electronic device 200 of FIG. 2A or FIG. 2B) may include a side surface member 310 (e.g., a side surface bezel structure), a first support member 311 (e.g., a bracket or support structure), a front surface plate 320 (e.g., a front surface cover) (e.g., the front surface plate 202 of FIG. 2A), a display 330 (e.g., the display 201 of FIG. 2A), a board 340 (e.g., a printed circuit board (PCB), a flexible printed circuit board (FPCB), or a rigid-flexible printed circuit board (RFPCB)), a battery 350, a second support member 360 (e.g., a rear case), an antenna 370, and a rear surface plate 380 (e.g., a rear surface cover) (e.g., the rear surface plate 211 of FIG. 2B). In an embodiment, the electronic device 300 may omit at least one of the components (e.g., the first support member 311 or the second support member 360) or may additionally include another component. At least one of the components of the electronic device 300 may be the same as or similar to at least one of the components of the electronic device 200 of FIG. 2A or FIG. 2B, and a repeated description will be omitted below.

The first support member 311 may be disposed inside the electronic device 300 and connected to the side surface member 310, or may be integrally formed with the side surface member 310. The first support member 311 may be formed of, for example, a metal material and/or a non-metal material (e.g., a polymer). The display 330 may be coupled to one surface of the first support member 311, and the board 340 may be coupled to the other surface of the first support member 311. A processor (e.g., the processor 120 of FIG. 1), memory (e.g., the memory 130 of FIG. 1), and/or an interface (e.g., the interface 177 of FIG. 1) may be mounted on the board 340. The processor may include, for example, one or more of a central processing unit, an application processor, a graphics processing unit, an image signal processor, a sensor hub processor, or a communication processor.

The memory may include, for example, volatile memory or non-volatile memory.

The interface may include, for example, a high-definition multimedia interface (HDMI), a universal serial bus (USB) interface, a secure digital (SD) card interface, and/or an audio interface. The interface may, for example, electrically or physically connect the electronic device 300 to an external electronic device, and may include a USB connector, an SD card/multimedia card (MMC) connector, or an audio connector.

The battery 350, as a device for supplying power to at least one component of the electronic device 300, may include, for example, a non-rechargeable primary battery, a rechargeable secondary battery, or a fuel cell. At least a portion of the battery 350 may be disposed, for example, substantially on the same plane as the board 340. The battery 350 may be integrally disposed inside the electronic device 300. In an embodiment, the battery 350 may be detachably disposed on the electronic device 300.

The antenna 370 may be disposed between the rear surface plate 380 and the battery 350. The antenna 370 may include, for example, a near field communication (NFC) antenna, a wireless charging antenna, and/or a magnetic secure transmission (MST) antenna. The antenna 370 may, for example, perform short-range communication with an external electronic device or wirelessly transmit and receive power required for charging. In an embodiment, an antenna structure may be formed by a portion of the side surface bezel structure 310 and/or the first support member 311, or a combination thereof.

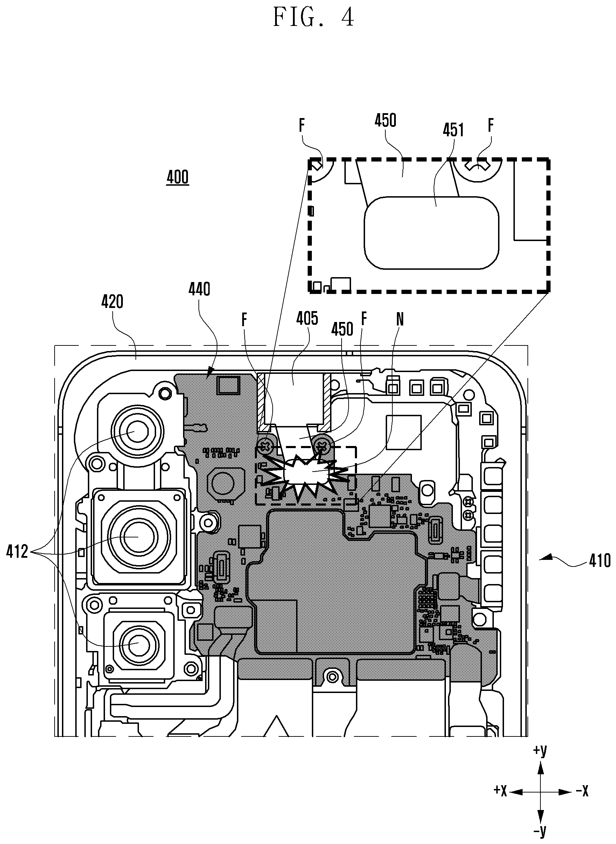

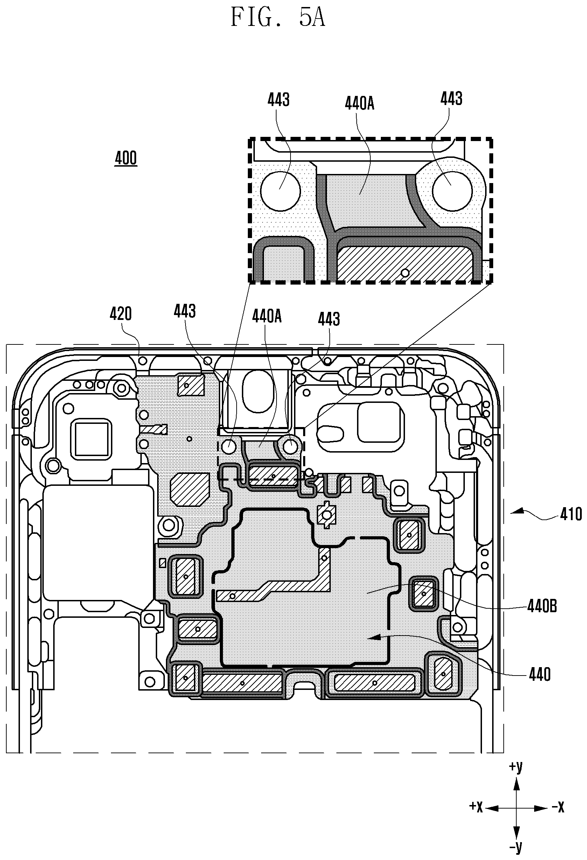

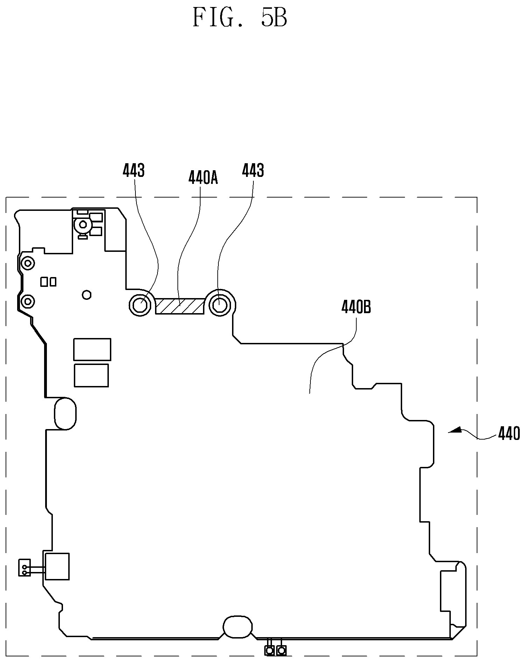

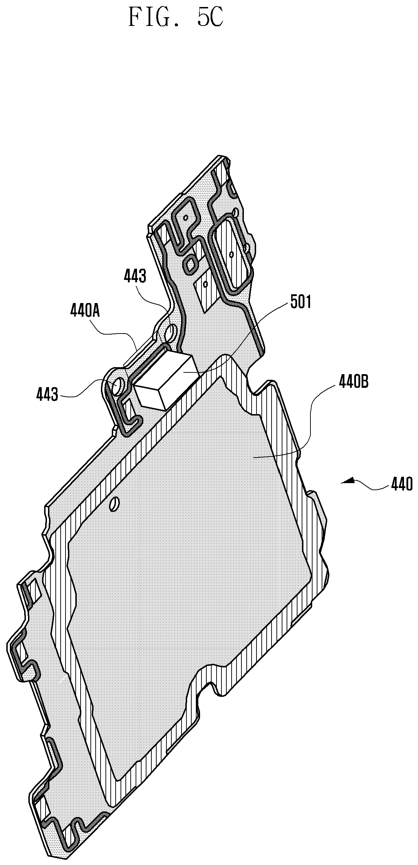

FIG. 4 is a rear view of an electronic device illustrating a state in which a printed circuit board and a camera module are connected via a flexible printed circuit board according to an embodiment of the disclosure. FIG. 5A is a view illustrating a printed circuit board disposed in a housing, as viewed from a rear side of an electronic device, according to an embodiment of the disclosure. FIG. 5B is a rear view of the printed circuit board according to an embodiment of the disclosure. FIG. 5C is a perspective view of the printed circuit board according to an embodiment of the disclosure.

Among descriptions of an electronic device 400 described below, descriptions of configurations that are the same as or similar to the configurations described with reference to FIGS. 1 to 3 will be omitted.

According to an embodiment, as illustrated in FIGS. 4 and 5A, the electronic device 400 (e.g., the electronic device 101 of FIG. 1, the electronic device 200 of FIG. 2A, and/or the electronic device 300 of FIG. 3) may include a housing 410 (e.g., the housing 210 of FIG. 2A) in which an electronic component is disposed and a frame 420 (e.g., the side surface member 310 of FIG. 3) surrounding a side surface of the housing 410. In an embodiment, the frame 420 may form an exterior of a side surface (e.g., the side surface 210C of FIG. 2A) of the electronic device 400. For example, the frame 420 may be arranged to surround the side surface of the housing 410, and at least a portion of the frame 420 may form a portion of the side surface of the electronic device 400. In an embodiment, the housing 410 may be disposed inside the frame 420, and electronic components constituting the electronic device 400 may be disposed in the housing 410. In an embodiment, the housing 410 and the frame 420 may be integrally formed. Alternatively, the frame 420 may be formed separately from the housing 410 and processed to be coupled to the housing 410. According to an embodiment, the housing 410 and the frame 420 may be formed using various processing methods, such as computer numerical control (CNC), die casting, or pressing.

According to an embodiment, the frame 420 may be formed of a conductive material (e.g., a metal material) and used as an antenna radiator. In an embodiment, the frame 420 may be electrically connected to the communication module 190 connected to the printed circuit board 440 of the electronic device 400, so as to transmit a communication signal (e.g., a radio frequency (RF) signal) to an external electronic device or receive a communication signal from an external electronic device.

In an embodiment, the frame 420 may be electrically connected to the printed circuit board 440 via an RF connection member (not illustrated). In an embodiment, the frame 420 may include a conductive portion. The RF connection member may be connected to the conductive portion of the frame 420. The communication module 190 may be disposed on the printed circuit board 440 and electrically connected to the frame 420 via the RF connection member. The RF connection member may transmit a communication signal processed by the communication module 190 of the electronic device 400 to the frame 420 serving as an antenna, or may transmit a communication signal received through the frame 420 to the communication module 190.

In an embodiment, the frame 420 may transmit or receive RF signals in various frequency bands. In an embodiment, the frame 420 may be electrically connected to the communication module 190 to transmit or receive RF signals in 2.4 GHz, 5 GHz, and/or 6 GHz bands. In an embodiment, the frame 420 may be electrically connected to the communication module 190 to transmit or receive RF signals in a high frequency band (e.g., 3.5 GHz to 28 GHz or 28 GHz to 100 GHz (mmWave)).

According to an embodiment, electronic components may be disposed inside the housing 410 at positions adjacent to the frame 420. In an embodiment, referring to FIG. 4, a front camera 405 (e.g., the camera module 180 of FIG. 1 and/or the first camera module 205 of FIG. 2A) and a rear camera 412 (e.g., the camera module 180 of FIG. 1 and/or the second camera module 212 of FIG. 2A) may be positioned adjacent to the frame 420.

According to an embodiment, an electronic component disposed in the housing 410 may be electrically connected to the printed circuit board 440 via the flexible printed circuit board 450. In an embodiment, the flexible printed circuit board 450 may be formed of a flexible material. In an embodiment, the flexible printed circuit board 450 may be physically and electrically connected to the printed circuit board 440 in various manners. In an embodiment, a connector 451 of the flexible printed circuit board 450 may be electrically connected to the printed circuit board 440 by an electrical connection method, such as soldering, clipping, socketing, bolting, and/or bonding.

Meanwhile, in a process of transmitting or receiving a communication signal through the frame 420, electrical noise (e.g., electrical noise N of FIG. 4) may be induced to peripheral electronic components through the printed circuit board 440. For example, in a process of transmitting a communication signal through the frame 420, power having a relatively higher intensity may be supplied to the printed circuit board 440 than in a process of receiving a communication signal. In particular, the printed circuit board 440 may transmit a communication signal at a maximum output to communicate with an external electronic device in a weak electric field environment, and power having a relatively high intensity may be supplied to the printed circuit board 440. In this case, electrical noise may be induced from the printed circuit board 440 to an electronic component disposed adjacent to the printed circuit board 440. In an embodiment, the electrical noise may be directly induced to the electronic component. In an embodiment, the electrical noise may be induced to the flexible printed circuit board 450 connecting the electronic component to the printed circuit board 440. As electrical noise generated in the printed circuit board 440 is induced to the flexible printed circuit board 450, interference may occur in a signal related to the electronic component transmitted from the printed circuit board 440 due to the electrical noise, and a malfunction may occur in the electronic component.

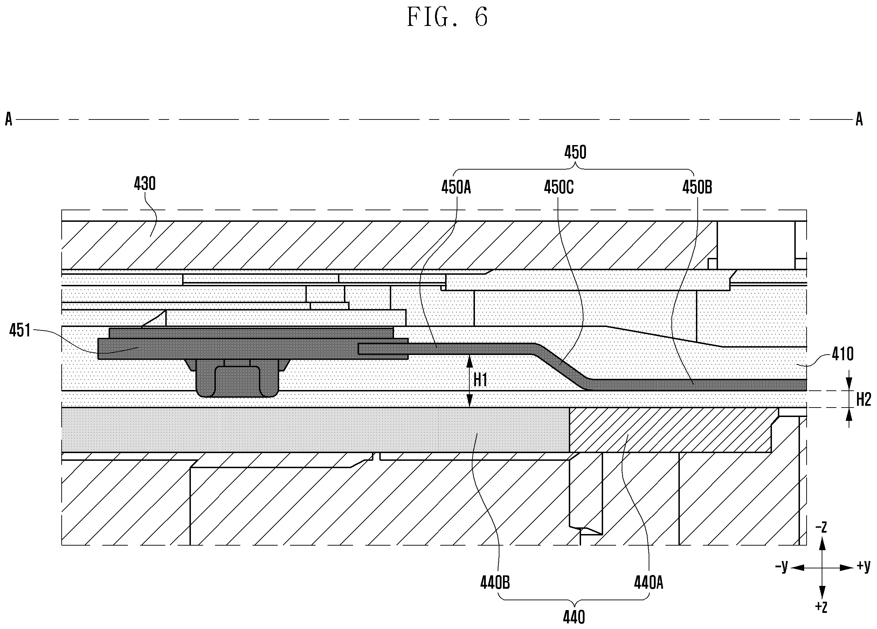

According to an embodiment, as illustrated in FIG. 4, the flexible printed circuit board 450 may be connected adjacent to the printed circuit board 440 so as to prevent separation of the flexible printed circuit board 450 from the printed circuit board 440 when an external impact (e.g., collision or drop) is applied to the electronic device 400. For example, referring to FIG. 6 to be described below, the flexible printed circuit board 450 may be connected adjacent to the printed circuit board 440 in a state in which at least a portion (e.g., a third portion 450C) is bent. In this case, when an external impact is applied to the electronic device 400, a degree to which the flexible printed circuit board 450 may move with respect to the printed circuit board 440 may be reduced, thereby reducing a phenomenon in which the flexible printed circuit board 450 is separated from the printed circuit board 440.

Meanwhile, when the flexible printed circuit board 450 and the printed circuit board 440 are disposed adjacent to each other, the flexible printed circuit board 450 and the printed circuit board 440 may come into contact with each other. As the flexible printed circuit board 450 comes into contact with or is adjacent to the printed circuit board 440, electrical noise generated in the printed circuit board 440 may be induced to the flexible printed circuit board 450. For example, when an antenna signal is transmitted through the frame 420, relatively high power may be generated at the printed circuit board 440. As the flexible printed circuit board 450 comes into contact with the printed circuit board 440, electrical noise associated with an antenna signal may be induced from the printed circuit board 440. As unnecessary electrical noise is induced to the flexible printed circuit board 450 and/or the electronic component, a malfunction or defect may occur in the electronic component. For example, when the electronic component is the front camera 405, as electrical noise is induced from the printed circuit board 440 to the flexible printed circuit board 450, interference may occur in a signal related to a camera function transmitted from the printed circuit board 440 due to the noise, and the camera function may malfunction. In an embodiment, a malfunction that may occur in the front camera 405 may be a malfunction such as preview image interruption, video interruption, or camera application operation abnormality, and various other malfunctions may also occur.

According to an embodiment of the disclosure, the printed circuit board 440 may include a fill cut structure in which a conductive layer positioned at a portion where contact with the flexible printed circuit board 450 may occur (e.g., a layer formed of a conductive material or a copper foil layer) is removed or omitted. For example, in the printed circuit board 440, a conductive layer (e.g., the conductive layer 4403) positioned in a region facing a portion (e.g., the second portion 450B) of the flexible printed circuit board 450 may be omitted or removed. In this case, even when the flexible printed circuit board 450 comes into contact with the printed circuit board 440, electrical noise generated in the printed circuit board 440 may not be induced to the flexible printed circuit board. Accordingly, a malfunction may not occur in an electronic component connected to the flexible printed circuit board 450 (e.g., the front camera). Hereinafter, a structure of the printed circuit board 440 that blocks transmission of electrical noise to the flexible printed circuit board 450 will be described in detail. In addition, the following description is provided based on an assumption that the flexible printed circuit board 450 is a configuration connecting the front camera 405 and the printed circuit board 440. However, the following embodiments may be equally applied to a flexible printed circuit board connecting an electronic component other than the front camera 405 and the printed circuit board 440.

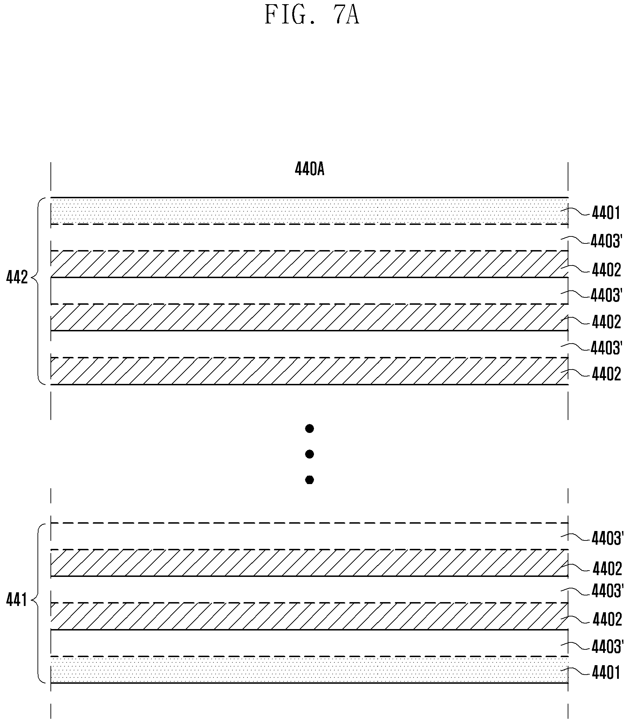

FIG. 6 is a cross-sectional view taken along line A-A illustrated in FIG. 2B. FIG. 7A is a view illustrating an embodiment in which a conductive layer is removed from a first region of a printed circuit board according to an embodiment of the disclosure.

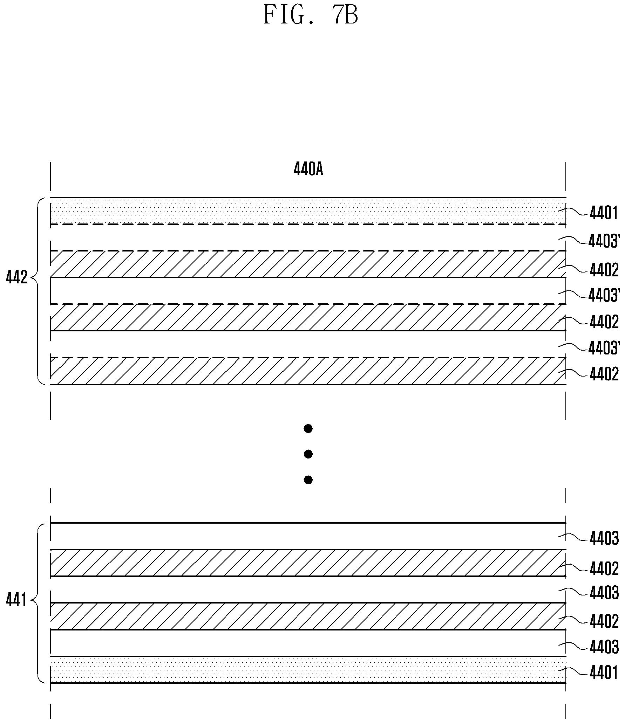

FIG. 7B is a view illustrating an embodiment in which a conductive layer is removed from some layers of a first region of a printed circuit board according to an embodiment of the disclosure.

According to an embodiment, as illustrated in FIG. 6, as the flexible printed circuit board 450 is formed of a flexible material, the flexible printed circuit board 450 may electrically connect the printed circuit board 440 and an electronic component (e.g., the front camera) in a bent state. In an embodiment, the flexible printed circuit board 450 may include a first portion 450A, a second portion 450B, and a third portion 450C (e.g., a bending portion) which connects the first portion 450A and the second portion 450B and is at least partially curved.

In an embodiment, referring to FIG. 6, the second portion 450B may be a portion closer to the electronic component (e.g., the front camera 405) than the first portion 450A. In an embodiment, the first portion 450A of the flexible printed circuit board 450 may be a portion relatively spaced farther apart from the printed circuit board 440 than the second portion 450B. In an embodiment, the first portion 450A of the flexible printed circuit board 450 may be spaced apart from the printed circuit board 440 by a first distance H1. The second portion 450B of the flexible printed circuit board 450 may be spaced apart from the printed circuit board 440 by a second distance H2 smaller than the first distance H1. In summary, when the printed circuit board 440 is viewed in a direction perpendicular to one surface of the printed circuit board 440 (e.g., the Z-axis direction of FIG. 6), the second portion 450B of the flexible printed circuit board 450 may be a portion relatively closer to the printed circuit board 440 than the first portion 450A.

According to an embodiment, the flexible printed circuit board 450 may come into contact with the printed circuit board 440 more frequently at the second portion 450B than at the first portion 450A. In the printed circuit board 440, in order to block an unnecessary electrical connection with the flexible printed circuit board 450, a conductive layer used as a ground layer or a signal layer (e.g., the conductive layer 4403) may be removed or omitted from a region (e.g., the first region 440A) overlapping the second portion 450B of the flexible printed circuit board 450 in a direction perpendicular to one surface of the printed circuit board 440 (e.g., the +Z direction of FIG. 6). For example, referring to FIGS. 7A and 7B, the printed circuit board 440 may include regions 4403' from which the conductive layer is removed in the first region 440A. In an embodiment, the regions 4403' from which the conductive layer is removed may be replaced with insulating layers 4402. Hereinafter, as illustrated in FIGS. 5A and 6 described above, a region of the printed circuit board 440 overlapping the second portion 450B of the flexible printed circuit board 450 in a direction perpendicular to one surface of the printed circuit board 440 will be defined as the first region 440A, and a remaining region other than the first region 440A will be defined as the second region 440B. The first region 440A of the printed circuit board 440 may be a region that may come into contact with the flexible printed circuit board 450.

In an embodiment, referring to FIG. 5A, the first region 440A may be closer to a region in which the front camera 405 is disposed than the second region 440B. In an embodiment, referring to FIGS. 5A, 5B, and 5C described above, at least a portion of the first region 440A may be positioned between fixing holes 443 into which fixing members for fixing the printed circuit board 440 to the housing 410 are inserted (e.g., the fixing members F of FIG. 4). In an embodiment, at least a portion of the second region 440B of the printed circuit board 440 may face the first portion 450A of the flexible printed circuit board 450.

According to an embodiment, the printed circuit board 440 may include a structure in which a plurality of layers (e.g., the first layer region 441 and the second layer region 442 of FIGS. 7A and 7B) are stacked. In an embodiment, the printed circuit board 440 may include conductive layers 4403 formed of a conductive material used for power supply or ground (e.g., a copper layer), solder masks 4401 (e.g., coating layers) stacked on a top surface and a bottom surface of the printed circuit board 440 to protect the conductive layer 4403, and insulating layers 4402 formed of an insulating material (e.g., a prepreg (preimpregnated material) layers). In an embodiment, the printed circuit board 440 may include a copper clad laminate (CCL) positioned between a plurality of prepregs.

According to an embodiment, as illustrated in FIG. 5C, a sensor 501 (e.g., a proximity sensor and/or an illuminance sensor) may be positioned adjacent to the first region 440A of the printed circuit board 440 and around the front camera 405. In an embodiment, in the printed circuit board 440, the first region 440A may not be physically removed so as to secure a region in which the sensor 501 is seated, and at least some of the conductive layers 4403 positioned in the first region 440A may be removed or omitted.

In an embodiment, referring to FIGS. 7A and 7B, the first region 440A of the printed circuit board 440 may include a first layer region 441 and a second layer region 442. In an embodiment, the first layer region 441 and the second layer region 442 may include a plurality of layers constituting the printed circuit board 440. In an embodiment, the second layer region 442 may be positioned between the first layer region 441 and the second portion 450B of the flexible printed circuit board 450. In the following description, the plurality of layers included in the printed circuit board 440 (e.g., the conductive layers 4403, the insulating layers 4402, and/or the solder masks 4401) will be described as being divided into the first layer region 441 and the second layer region 442. However, this is merely an example, and the plurality of layers included in the printed circuit board 440 may be divided into various layer regions.

In an embodiment, referring to FIGS. 6 and 7A, a conductive layer (e.g., the conductive layer 4403) may be removed or omitted from the first region 440A of the printed circuit board 440. For example, the first region 440A of the printed circuit board 440 may include regions 4403' from which the conductive layer is removed. In other words, the first region 440A of the printed circuit board 440 may be formed only of an insulating material (e.g., the insulating layers 4402 or the solder masks 4401), and may not include the conductive layers 4403. For example, the first layer region 441 and the second layer region 442 of the first region 440A may be formed only of an insulating material (e.g., the insulating layers 4402 or the solder masks 4401). In this case, the conductive layers 4403 may be positioned only in the second region 440B of the printed circuit board 440. Accordingly, when the second portion 450B of the flexible printed circuit board 450 comes into contact with the first region 440A of the printed circuit board 440, electrical noise may not be induced from the printed circuit board 440 to the flexible printed circuit board 450.

In an embodiment, referring to FIG. 7B, in the first region 440A of the printed circuit board 440, conductive layers (e.g., the conductive layers 4403) positioned adjacent to the second portion 450B of the flexible printed circuit board 450 may be removed or omitted. In an embodiment, in the first region 440A of the printed circuit board 440, when the printed circuit board 440 is viewed in a direction perpendicular to the printed circuit board 440 (e.g., the +Z direction of FIG. 6), conductive layers (e.g., the conductive layers 4403) may be removed from a layer adjacent to the second portion 450B of the flexible printed circuit board 450 (e.g., the second layer region 442). In an embodiment, the first layer region 441 relatively spaced farther apart from the second portion 450B of the flexible printed circuit board 450 than the second layer region 442 may include the conductive layers 4403.

In an embodiment, referring to FIG. 7B, the first layer region 441 may include the conductive layers 4403. In an embodiment, the conductive layers 4403 of the first layer region 441 may be signal wires or ground layers. Accordingly, in the printed circuit board 440, the conductive layers 4403 may be removed from a layer adjacent to the second portion 450B of the flexible printed circuit board 450 (e.g., the second layer region 442). When the second portion 450B of the flexible printed circuit board 450 comes into contact with the first region 440A of the printed circuit board 440, electrical noise may not be induced from the printed circuit board 440 to the flexible printed circuit board 450. Meanwhile, the conductive layers 4403 disposed in the first layer region 441 of the printed circuit board 440 may be used as signal wires or ground layers.

According to an embodiment, in a state in which a region for disposing the sensor 501 in the printed circuit board 440 is secured, at least a portion of the first region 440A of the printed circuit board 440 may be physically removed. In this case, as physical contact between the second portion 450B of the flexible printed circuit board 450 and the printed circuit board 440 is blocked, electrical noise caused by contact may not be induced from the printed circuit board 440 to the flexible printed circuit board 450.

According to an embodiment, an insulating member formed of an insulating material (e.g., an insulating tape) may be disposed between the first region 440A of the printed circuit board 440 and the second portion 450B of the flexible printed circuit board 450. In an embodiment, the insulating member may be attached to a surface of the first region 440A of the printed circuit board 440 facing the second portion 450B of the flexible printed circuit board 450. The insulating member may block electrical noise induced from the printed circuit board 440 to the flexible printed circuit board 450.

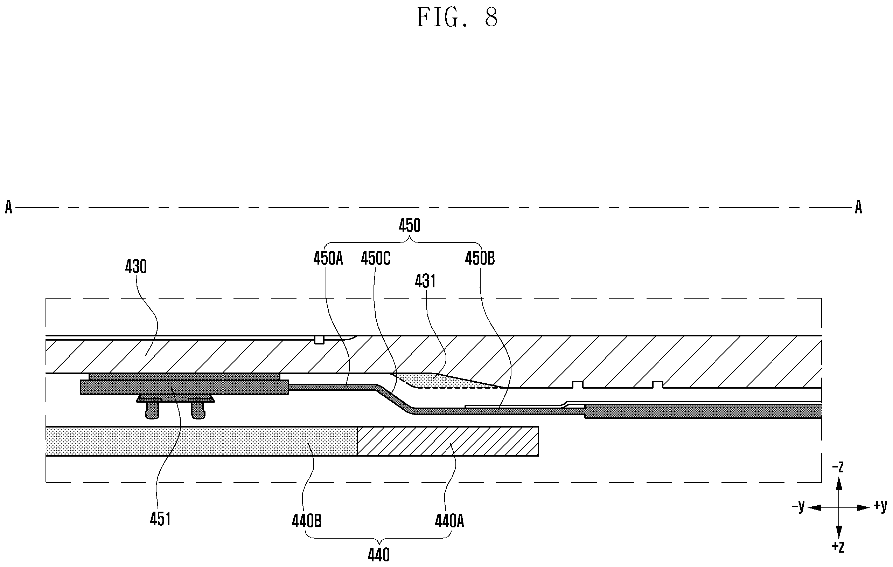

According to an embodiment, as illustrated in FIG. 8, the flexible printed circuit board 450 may be covered by a cover member 430 (e.g., the rear surface plate 380 of FIG. 3). In an embodiment, the flexible printed circuit board 450 may be disposed between the printed circuit board 440 and the cover member 430. In an embodiment, a groove 431 may be formed in a portion of the cover member 430 facing the second portion 450B of the flexible printed circuit board 450. In an embodiment, the groove 431 may be a portion formed by removing, from one portion of the cover member 430, a region facing the second portion 450B of the flexible printed circuit board 450. Accordingly, the second portion 450B of the flexible printed circuit board 450 is not pressed by the cover member 430, so that contact between the second portion 450B and the printed circuit board 440 may be prevented or a frequency of contact may be reduced.

According to an embodiment of the disclosure, in the printed circuit board 440, the conductive layers 4403 may be removed or omitted from the first region 440A overlapping the second portion 450B of the flexible printed circuit board 450. Accordingly, when the first region 440A of the printed circuit board 440 comes into contact with the flexible printed circuit board 450, an electrical signal and/or electrical noise generated in the printed circuit board 440 may not be induced to the flexible printed circuit board 450. For example, even when power of 17 dBm or more is generated in the printed circuit board 440 to transmit an antenna signal to an external electronic device, the electrical signal and/or the electrical noise may not be induced to the flexible printed circuit board 450. Accordingly, a malfunction of an electronic component connected to the flexible printed circuit board 450 (e.g., the front camera 405) may be prevented.

According to an embodiment disclosed herein, an electronic device 101, 200, 300, or 400 may include an electronic component. In an embodiment, the electronic device may include a printed circuit board 340 or 440 including a conductive layer 4403. In an embodiment, the electronic device may include a flexible printed circuit board 450 connecting the electronic component to the printed circuit board, and including a first portion 450A spaced apart from the printed circuit board by a first distance and a second portion 450B spaced apart from the printed circuit board by a second distance smaller than the first distance. In an embodiment, the printed circuit board may include a first region 440A overlapping the second portion of the flexible printed circuit board in a direction perpendicular to one surface of the printed circuit board, the conductive layer being removed from the first region, and a second region 440B other than the first region.

In an embodiment, the electronic device may further include a cover member 380 or 430 arranged to cover the flexible printed circuit board, and including a groove 431 formed in a portion facing the second portion.

In an embodiment, the electronic device may further include a frame 310 or 420 including a conductive material and at least partially forming a side surface exterior of the electronic device. In an embodiment, the electronic device may further include a communication module 190 disposed on the printed circuit board and electrically connected to the frame so that the frame transmits and receives a communication signal. In an embodiment, the electronic component may be disposed in a region adjacent to the frame.

In an embodiment, a signal generated in the printed circuit board may not be induced to the second portion of the flexible printed circuit board as the conductive layer is removed from the first region of the printed circuit board.

In an embodiment, the electronic component may be disposed closer to the first region than to the second region of the printed circuit board.

In an embodiment, the printed circuit board may include a plurality of fixing holes 443 into which fixing members are inserted, and at least a portion of the first region of the printed circuit board may be positioned between the plurality of fixing holes.

According to an embodiment of the disclosure, an electronic device 101, 200, 300, or 400 may include an electronic component. In an embodiment, the electronic device may include a printed circuit board 340 or 440 including a conductive layer 4403. In an embodiment, the electronic device may include a flexible printed circuit board 450 connecting the electronic component to the printed circuit board, and including a first portion 450A spaced apart from the printed circuit board by a first distance and a second portion 450B spaced apart from the printed circuit board by a second distance smaller than the first distance. In an embodiment, the printed circuit board may include a first region 440A overlapping the second portion of the flexible printed circuit board in a direction perpendicular to one surface of the printed circuit board, and a second region 440B other than the first region. In an embodiment, the first region of the printed circuit board may include a first layer region 441 and a second layer region 442 disposed between the first layer region and the second portion of the flexible printed circuit board, the conductive layer being removed from the second layer region.

In an embodiment, the conductive layer of the printed circuit board may be removed from the first layer region.

In an embodiment, the first layer region may include the conductive layer of the printed circuit board.

In an embodiment, the electronic device may further include a cover member 380 or 430 arranged to cover the flexible printed circuit board, and including a groove 431 formed in a portion facing the second portion.

In an embodiment the electronic device may further include a frame 310 or 420 including a conductive material and at least partially forming a side surface exterior of the electronic device. In an embodiment, the electronic device may further include a communication module 190 disposed on the printed circuit board and electrically connected to the frame so that the frame transmits and receives a communication signal. In an embodiment, the electronic component may be disposed in a region adjacent to the frame.

In an embodiment, a signal generated in the printed circuit board may not be induced to the second portion of the flexible printed circuit board as the conductive layer is removed from the second layer region located in the first region of the printed circuit board.

In an embodiment, the electronic component may be disposed closer to the first region than to the second region of the printed circuit board.

In an embodiment, the printed circuit board may include a plurality of fixing holes 443 into which fixing members are inserted. In an embodiment, at least a portion of the first region of the printed circuit board may be positioned between the plurality of fixing holes.

In a printed circuit board 340 or 440 electrically connected to an electronic component disposed in an electronic device 101, 200, 300, or 400 according to an embodiment of the disclosure through a flexible printed circuit board 450, the flexible printed circuit board may include a first portion 450A spaced apart from the printed circuit board by a first distance and a second portion 450B spaced apart from the printed circuit board by a second distance smaller than the first distance. In an embodiment, the printed circuit board may include a first region 440A overlapping the second portion of the flexible printed circuit board in a direction perpendicular to one surface of the printed circuit board, and a second region 440B other than the first region.

In an embodiment, the first region of the printed circuit board may include a first layer region 441 and a second layer region 442 disposed between the first layer region and the second portion of the flexible printed circuit board, the conductive layer 4403 being removed from the second layer region.

In an embodiment, the conductive layer 4403 of the printed circuit board may be removed from the first layer region.

In an embodiment, the first layer region may include the conductive layer 4403.

In an embodiment, the electronic device may further include a cover member 380 or 430 arranged to cover the flexible printed circuit board, and including a groove 431 formed in a portion facing the second portion.

In an embodiment, the electronic device may further include a frame 310 or 420 including a conductive material and at least partially forming a side surface exterior of the electronic device, and a communication module 190 disposed on the printed circuit board and electrically connected to the frame so that the frame transmits and receives a communication signal. In an embodiment, the electronic component may be disposed in a region adjacent to the frame.

In an embodiment, a signal generated in the printed circuit board may not be induced to the second portion of the flexible printed circuit board as the conductive layer is removed from the second layer region located in the first region of the printed circuit board.

It is to be understood that various embodiments of the disclosure and terms for describing the embodiments are not intended to limit the technical features disclosed herein to specific embodiments, and that the embodiments include various modifications, equivalents, or alternatives of the corresponding embodiments. In relation to the description of the drawings, similar reference numerals may be used for similar or related components. The singular form of a noun corresponding to an item may include one item or a plurality of items unless the context clearly indicates otherwise. In the disclosure, each of phrases, such as "A or B," "at least one of A and B," "at least one of A or B," "A, B, or C," "at least one of A, B, and C," and "at least one of A, B, or C" may include any one of the items listed together in the corresponding phrase or all possible combinations of the items. Such terms as "a first", "a second", "the first", and "the second" may be used to simply distinguish a corresponding element from another, and does not limit the elements in other aspect (e.g., importance or order). When a certain (e.g., a first) component is mentioned as being "coupled" or "connected" to another (e.g., a second) component, with or without a term "functionally" or "communicatively," it means that the certain component may be connected to the other component directly (e.g., wiredly), wirelessly, or via a third component.

According to various embodiments, each component (e.g., a module or a program) of the above-described components may include a single entity or multiple entities, and some of the multiple entities may be separately disposed in different components. According to various embodiments, one or more of the components or operations described above may be omitted, or one or more other components or operations may be added. Alternatively, or additionally, multiple components (e.g., modules or programs) may be integrated into a single component. In such a case, the integrated element may perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

It will be understood that, in addition to the above-disclosed embodiments, the disclosure also contemplates and includes embodiments based on combinations of any two or more of the above-disclosed embodiments and embodiments including any combination of the above-described features. They are disclosed herein. That is, the absence of an explicit indication that two features may be combined or two embodiments may be combined does not mean that such combinations are not contemplated, but such combinations should be considered to be included herein.

## Claims

1. An electronic device (101, 200, 300, 400) comprising:
an electronic component;
a printed circuit board (340, 440) comprising a conductive layer (4403); and
a flexible printed circuit board (450) connecting the electronic component to the printed circuit board, and comprising a first portion (450A) spaced apart from the printed circuit board by a first distance and a second portion (450B) spaced apart from the printed circuit board by a second distance smaller than the first distance,
wherein the printed circuit board comprises:
a first region (440A) overlapping the second portion of the flexible printed circuit board in a direction perpendicular to one surface of the printed circuit board, the conductive layer being removed from the first region, and
a second region (440B) other than the first region.

2. The electronic device of claim 1, further comprising:
a cover member (380, 430) arranged to cover the flexible printed circuit board, and comprising a groove (431) formed in a portion facing the second portion.

3. The electronic device of claim 1, further comprising:
a frame (310, 420) comprising a conductive material and at least partially forming a side surface exterior of the electronic device; and
a communication module (190) disposed on the printed circuit board and electrically connected to the frame so that the frame transmits and receives a communication signal,
wherein the electronic component is disposed in a region adjacent to the frame.

4. The electronic device of claim 3, wherein a signal generated in the printed circuit board is not induced to the second portion of the flexible printed circuit board as the conductive layer is removed from the first region of the printed circuit board.

5. The electronic device of claim 1, wherein the electronic component is disposed closer to the first region than to the second region of the printed circuit board.

6. The electronic device of claim 1, wherein the printed circuit board comprises a plurality of fixing holes (443) into which fixing members are inserted, and
wherein at least a portion of the first region of the printed circuit board is positioned between the plurality of fixing holes.

7. An electronic device (101, 200, 300, 400) comprising:
an electronic component;
a printed circuit board (340, 440) comprising a conductive layer (4403); and
a flexible printed circuit board (450) connecting the electronic component to the printed circuit board, and comprising a first portion (450A) spaced apart from the printed circuit board by a first distance and a second portion (450B) spaced apart from the printed circuit board by a second distance smaller than the first distance,
wherein the printed circuit board comprises a first region (440A) overlapping the second portion of the flexible printed circuit board in a direction perpendicular to one surface of the printed circuit board, and a second region (440B) other than the first region, and
wherein the first region of the printed circuit board comprises a first layer region (441) and a second layer region (442) disposed between the first layer region and the second portion of the flexible printed circuit board, the conductive layer being removed from the second layer region.

8. The electronic device of claim 7, wherein the conductive layer of the printed circuit board is removed from the first layer region.

9. The electronic device of claim 7, wherein the first layer region comprises the conductive layer of the printed circuit board.

10. The electronic device of claim 7, further comprising:
a cover member (380, 430) arranged to cover the flexible printed circuit board, and comprising a groove (431) formed in a portion facing the second portion.

11. The electronic device of claim 7, further comprising:
a frame (310, 420) comprising a conductive material and at least partially forming a side surface exterior of the electronic device; and
a communication module (190) disposed on the printed circuit board and electrically connected to the frame so that the frame transmits and receives a communication signal,
wherein the electronic component is disposed in a region adjacent to the frame.

12. The electronic device of claim 11, wherein a signal generated in the printed circuit board is not induced to the second portion of the flexible printed circuit board as the conductive layer is removed from the second layer region located in the first region of the printed circuit board.

13. The electronic device of claim 7, wherein the electronic component is disposed closer to the first region than to the second region of the printed circuit board.

14. The electronic device of claim 7, wherein the printed circuit board comprises a plurality of fixing holes (443) into which fixing members are inserted, and
wherein at least a portion of the first region of the printed circuit board is positioned between the plurality of fixing holes.
